(19) **Europäisches Patentamt**

**European Patent Office**

**Office européen des brevets**

(11) **EP 1 564 809 A1**

(12) **EUROPEAN PATENT APPLICATION**

(43) Date of publication:
**17.08.2005 Bulletin 2005/33**

(51) Int Cl.⁷: **H01L 23/473**

(21) Application number: **04021061.9**

(22) Date of filing: **03.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **16.02.2004 JP 2004038157**

(71) Applicant: **Hitachi, Ltd.**
**Chiyoda-ku, Tokyo 100-8010 (JP)**

(72) Inventors:
• **Ohashi, Shigeo, Hitachi, Ltd.**
**Chiyoda-ku Tokyo 100-8220 (JP)**

• **Naganawa, Takashi, Hitachi, Ltd.**
**Chiyoda-ku Tokyo 100-8220 (JP)**
• **Minamitani, Rintaro, Hitachi, Ltd.**
**Chiyoda-ku Tokyo 100-8220 (JP)**
• **Nishihara, Atsuo, Hitachi, Ltd.**
**Chiyoda-ku Tokyo 100-8220 (JP)**

(74) Representative: **Beetz & Partner Patentanwälte**
**Steinsdorfstrasse 10**
**80538 München (DE)**

(54) **Liquid cooling system and electronic apparatus comprising that system**

(57) The invention relates to a liquid cooling system for electronic apparatuses and electronic apparatuses comprising that system. The cooling system for electronic apparatuses for enabling a cooling operation of a heat-generating element such as a CPU (200) which is mounted within a housing of the apparatus and needs cooling, comprises a cooling jacket (50), a radiator (60) and a circulation pump (70), wherein the cooling jacket (50) comprises a base-plate portion (51) being made of a material superior in heat conductivity, such as copper or the like, and formed with a flow inlet (54) and a flow outlet (55) for the liquid coolant as well as a flow passage formed in a "U" or an "I" shape within the inside thereof, and a cover portion (52); in a portion of the flow passage of the "U" or "I" shape is disposed a coolant division portion (56 and/or 57) being made up by combining a plural number of pieces of fine tubes in a bundle, each of which is also made of a material superior in heat conductivity, such as copper or the like, through brazing.

FIG.1

## Description

BACKGROUND OF THE INVENTION

The present invention relates to an electronic apparatus, such as a personal computer of being so-called a desktop type or a notebook type, and/or a server, etc., for example, and in particular, it relates to an electronic apparatus having a liquid cooling system therein, for enabling to cool down a semiconductor integrated circuit (IC) element(s), i.e., a heat-generating element, that is mounted within the inside thereof, effectively, with the aid of a liquid coolant. The invention further relates to the liquid coolant system.

In general, cooling is necessary for the semiconductor IC element, which constitutes a heat-generating body within an electronic apparatus, such as a personal computer of so-called desktop type or notebook type and/or a server, etc., in particular, a CPU (Central Processing Unit), so as to ensure the normal operation thereof. For that purpose, conventionally, it is common to achieve the cooling for it, with using a heat transfer material, with which fins are formed in one body, i.e., a so-called heat sink and also a fan for supplying cooling air thereon. However, in recent years, small-sizing and high-integration of semiconductor IC elements, i.e., the heat-generating elements, results in a localization of the heat generation, in particular, at a portion where the heat is generated within the heat-generating element, and also for this reason, in the place of the conventional cooling system such as of an air-cooling type, attention is paid upon a cooling system of a liquid-cooling type, applying a coolant therein, such as water or the like, for example, and having a high efficiency in the cooling operation thereof.

Namely, in the cooling system of applying such the liquid-cooling type therein, having a high cooling efficiency, to be used in the personal computer of so-called desktop type or notebook type, and/or a server, etc., as was already known from the following patent documents, etc., in general, upon a surface of the CPU, as being the heat generating body, is directly mounted a member, such as a so-called heat-receiving (or cooling) jacket, while conducting a liquid-like coolant to flow within a flow passage formed within the inside of the heat-receiving jacket, so as to transfer the generated heat from the CPU into the coolant flowing within the jacket mentioned above, thereby achieving the cooling of the heat generating body at high efficiency. Further, in such a cooling system of the liquid-cooling type, it is common to make up a heat cycle, in which the cooling jacket functions as a heat receiving portion, and in more details thereof, it comprises a circulation pump for circulating the liquid coolant within a cycle, a heat radiating portion for radiating heat of the liquid coolant to the outside, i.e., a so-called radiator, and further a coolant tank, which is provided in a part of the cycle, but depending upon the necessity thereof, wherein those are connected through tubes made of metal and/or those made of an elastic material, such as rubber or the like, for example.

Patent Document 1: Japanese Patent Laid-Open No. Hei 6-266474 (1994);
Patent Document 2: Japanese Patent Laid-Open No. Hei 7-142886 (1995); and
Patent Document 3: Japanese Patent Laid-Open No. 2003-78270 (2003).

BRIEF SUMMARY OF THE INVENTION

By the way, with such a cooling system relating to the conventional art as mentioned above, having a high cooling efficiency, in particular, the heat-receiving (or cooling) jacket is in contact with the CPU, i.e., the heat-generating body, directly, while circulating a liquid coolant within the inside thereof, thereby discharging the heat into the outside thereof, and it is constructed by forming a fine passage, such as, of about 2 mm in the inner diameter, being wound in a zigzag manner, or spiral-like, within the inside of a member of being superior in heat transfer, such as copper or the like, for example. For this reason, it is complex in the manufacturing process thereof, as well as difficult to reduce the manufacturing cost thereof, and this comes to be one of the reasons of rising up the total cost of such cooling systems. Further, this also comes up to be a large problem, in particular, in a case when applying such a liquid-type cooling system having high cooling efficiency into a personal computer, being of so-called desktop-type or notebook-type, and/or a server, etc., which are in tendency that the sales prices thereof come down, every year, due to the effect of mass production thereof.

The present invention has been accomplished by taking the problems relating to the conventional art mentioned above into consideration. It is the underlying problem of the present invention to provide a liquid cooling system and an electronic apparatus comprising a cooling system, by using a heat-receiving(cooling)jacket being simple and easy to manufacture, so as to lower the manufacturing cost, thereby being applicable as a cooling system for computers of desktop or notebook-type, as well as for servers, etc., for which there is the tendency that the sales prices thereof come down, every year, due to the effect of mass production thereof.

The above problem is solved according to the independent claims. The dependent claims relate to preferred embodiments of the concept of the present invention.

According to the present invention, for accomplishing the object mentioned above, there is provided an electronic apparatus comprising: a heat-generating semiconductor element being installed within the inside of a housing thereof, which element necessitates cooling thereof for maintaining normal operation thereof, and a liquid cooling system being provided within the housing or in a part thereof, and the liquid cooling system comprising: a cooling jacket being thermally connected with the semiconductor element for transmitting the generated heat thereof into a liquid coolant flowing within the inside thereof; a radiator for discharging the heat, which is transmitted to the liquid coolant within the cooling jacket, into the outside of the apparatus, and a circulation pump for circulating the liquid coolant within a loop, including therein the cooling jacket and the radiator, wherein the heat-receiving jacket comprises: a base-plate portion being about plate-like in its outer configuration and opened in the upper surface side thereof, made of a material superior in heat transfer or heat conductivity and further formed with a flow inlet and a flow outlet for the liquid coolant, as well as a flow passage formed within the inside thereof, directing from the flow inlet to the flow outlet; a coolant division portion, being made up with a plural number of pieces of fine tubes tied in a bundle, each being made of a material superior in heat transfer or heat conductivity so that the liquid coolant flows inside each fine tube, dividedly, and a cover portion attached to the base-plate portion on the opened upper surface side thereof, after disposing the coolant division portion in a portion of the flow passage defined within the base-plate portion.

Further, according to the present invention, in the electronic apparatus as described in the above, the flow passage directing from the flow inlet to the flow outlet may be formed into a "U" shape, or an "I" shape, within the base-plate portion building up the cooling jacket. Or, the coolant division portion for building up the cooling jacket is made up by connecting a plural number of pieces of the fine tubes while aligning them in one single stage, or in a plural number of stages thereof. Also, according to the present invention, it is preferable that the fine tubes of the coolant division portion for building up the cooling jacket have an inner diameter of 0.5 to 1.5 mm.

BRIEF DESCRIPTION OF THE DRAWINGS

Those and other objects, features and advantages of the present invention will become more readily apparent from the following detailed description when taken in conjunction with the accompanying drawings wherein:

Fig. 1 is a partially enlarged explosive view for showing the detailed structure of a heat-receiving (or cooling) jacket, in particular, within a cooling system of an electronic apparatus, according to an embodiment of the present invention;

Fig. 2 is a perspective view, partially exploded therein, for showing an example of an arrangement of each portion, within an inside of the electronic apparatus, installing the cooling system mentioned above therein, in particular, such as, a desk-top type personal computer, for example;

Fig. 3 is a perspective view for showing the entire structure of the cooling system in the electronic apparatus shown in the above;

Fig. 4 is a perspective view, partially exploded therein, for showing the detailed structure of the heat-receiving (or cooling) jacket, according to other embodiment;

Fig. 5 attached herewith is shows a cross-section view for showing a variation of the heat-receiving (or cooling) jacket mentioned above;

Fig. 6 is a perspective view, partially exploded therein, for showing the detailed structure of the heat-receiving (or cooling) jacket, according to further other embodiment;

Figs. 7 (a) to 7 (c) are views for showing other manufacturing method of the heat-receiving (or cooling) jacket mentioned above, and in particular, Fig. 7 (a) a plane view of the heat-receiving (or cooling) jacket but removing a cover member therefrom, and Fig. 7(b) the A-A cross-section view and Fig. 7(c) the B-B cross-section view in Fig. 7(a);

Fig. 8 is a cross-section view for showing an embodiment of aligning fine tubes, at an appropriate distance therebetween, in the heat-receiving (or cooling) jacket mentioned above;

Figs. 9 (a) and 9 (b) are views for showing the heat-receiving (or cooling) jacket mentioned above, further other embodiment of the present inventing;

Fig. 10 is a cross-section view for showing the interior structure of a variation of the heat-receiving (or cooling) jacket mentioned above; and

Figs. 11 (a) and 11 (b) are views for showing other variation of the heat-receiving (or cooling) jacket mentioned above, also according to the present inventing.

DETAILED DESCRIPTION OF THE INVENTION

Hereinafter, embodiments according to the present invention will be fully explained by referring to the attached drawings.

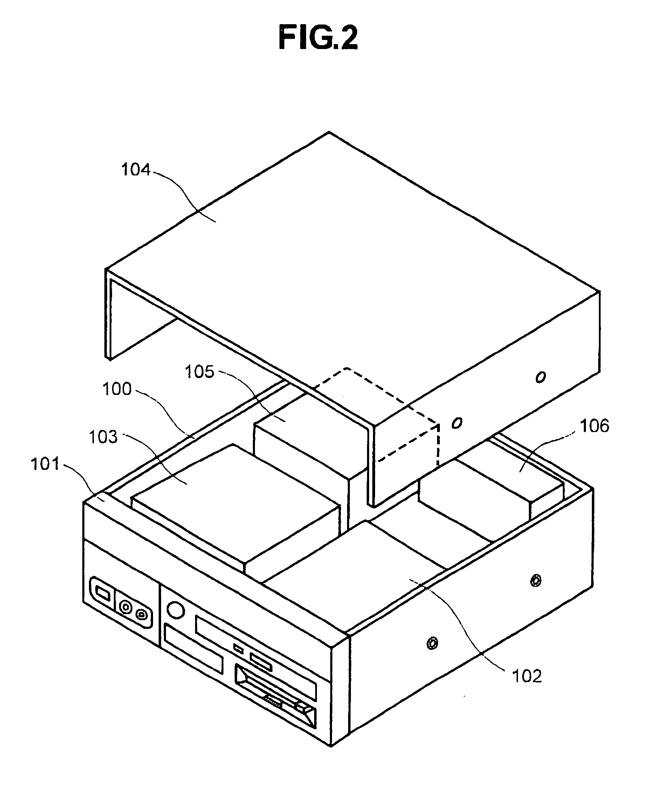

First of all, Fig. 2 attached herewith shows an example of the entire structure of an electronic apparatus having a liquid-cooling system therein, according to an embodiment of the present invention. However, in the present example, there is shown a case where the present invention is applied into a main body of a desk-top-type personal computer, for example.

The main body of the desktop-type personal computer has, as shown in the figure, a housing 100, which is made from a metal plate forming into a cubic shape, for example, on a front panel portion 101 of which are provided various kinds of switches, including, such as, an electric power switch, for example, and also connector terminals and an indicator lamp, etc. In the inside thereof is disposed a driver apparatus 102 for driving various kinds of external information recording media, such as, a disk, a CD, a DVD, etc., in such a manner that an opening is made on the front panel portion 101. Also, reference numeral 103 depicts a memory portion provided within the inside of the housing 100, being made from a hard disk device, for example. And reference numeral 104 in the figure depicts a cover portion or member to be put on the housing 100.

On the other hand, on the rear side surface of the housing 100 is disposed an electronic circuit portion 105, including the liquid cooling system according to the present invention therein. Also, a reference numeral 106 in the figure depicts an electric power portion for supplying desired electric power sources from a commercial electric power source to the respective portions, including the driver apparatus 102, the memory portion 103, and the electronic circuit portion 105.

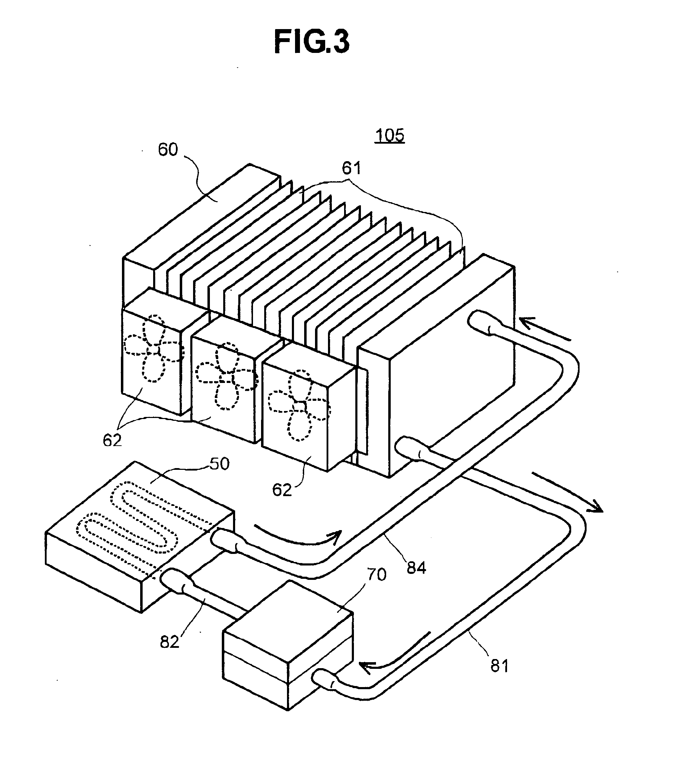

Next, Fig. 3 attached herewith shows the electronic circuit portion 105 in the desktop-type personal computer, i.e., the electronic apparatus, the brief structure of which was explained in the above, in particular, those centering around a heat-receiving jacket 50, which mounts thereon a heat-generating element, as being a main constituent part thereof. However, in the present example, a chip 200 of the CPU, i.e., the heat-generating element, is mounted onto the lower surface of the heat-receiving jacket 50, being directly in contact with, and for this reason, it is not illustrated in the figure herein.

And, as is apparent from the figure, the electronic circuit portion 105 is connected with the heat-receiving (or cooling) jacket 50 mounting the CPU thereon, a radiator portion 60 for radiating the generated heat from the CPU into the outside of the apparatus, a circulation pump 70, and flow passages for conducting a liquid coolant (for example a water, or a water mixed with an anti-freezing solution, such as propylene glycol or the like, for example) to flow into the respective parts, which build up the heat cycle with those mentioned above, by means of tubes (or conduits) 81, 82 and 84, each of which is made of a metal, for example, i.e., of causing hardly the leakage of liquid coolant stored within the inside to the outside thereof. Also, in a part of the radiator portion 60 mentioned above, there are attached plate-type fans 62, 62... (in plural numbers thereof, in this embodiment, three pieces, for example) for blasting air onto a large number of fins 61 forming as the constituent elements thereof, thereby radiating the heat transmitted from the heat-receiving jacket 50, compulsively, directing into the outside of the apparatus. Further, this heat-receiving (or cooling) jacket 50 is that formed from a plate-like member, being made of a metal having high heat conductivity, such as copper or the like, for example, and it is also formed with a cooling passage within the inside thereof, to conduct the liquid coolant to flow into the inside of the passage, thereby for removing (or moving) the generated heat from the CPU into the outside.

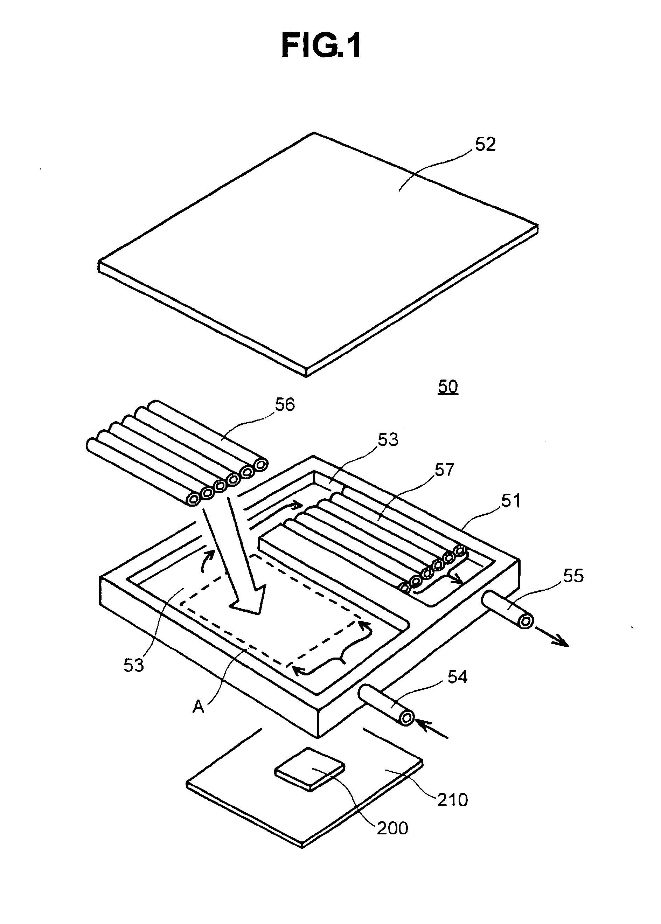

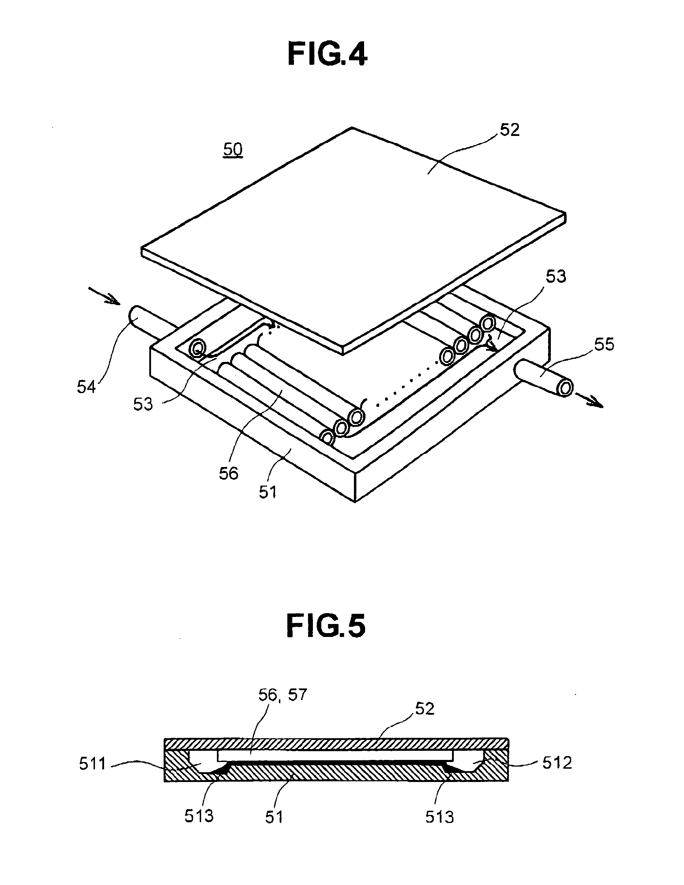

Following to the above, in Fig. 1 attached is shown the interior structure of the heat-receiving (or cooling) jacket 50 mentioned above, in the details thereof. As apparent from the figure, it is constructed with a base-plate member 51, being plate-like (for example, about from 40 mm x 60 mm) in the outer configuration thereof, and a cover member 52 attached thereon, covering over the upper surface thereof. Further, that base-plate member 51 and the cover member 52 are made of a material which is superior in the heat transfer thereof, such as copper or the like. And, within the inside of the base-plate portion 51 of being about plate-like, there are defined flow passages 53 in the form of a recess or a concave portion, which are formed through press work, etc., for example. However, in the example shown in this Fig. 1, the flow passages, which are formed with the recess or concave portion, are defined into a shape of about a "U", and for this reason, an inlet 54 and an outlet 55 for the liquid coolant are formed upon the same side-surface of the four side surfaces of the base-plate member 51. Also, though it will be explained later, in the example shown in Fig. 4, those recess or concave portions are formed to be only the recess or concave portions, direction from one end surface to the other end surface, opposing to each other; i.e., as a flow passage in a shape of an "I". Also, in this case, the inlet 54 and the outlet 55 for the liquid coolant are formed, not on the same side surface of the base-plate portion 51, but on the two side surfaces thereof opposing to each other.

And, in a portion of the flow passages formed with the recess or concave portion, in particular, in the case shown in Fig. 1, within the flow passages 53 formed in the "U" shape mentioned above, there are provided, so-called coolant separation flow passages (portions) 56 and 57, respectively, for dividing or separating the liquid coolant flowing therein into finer flow passages. However, those coolant separation flow passages (portions) 56 and 56 are constructed, as apparent from the figure, by combining fine tubes, also being made of a material being superior in the heat transfer, such as copper or the like, for example, in a plural number of pieces thereof (i.e., connecting or combining them in a bundle). In more details, each of them is constructed, by connecting between the copper fine tubes, each having an inner diameter form 0.5 to 1.5 mm and an outer diameter 1.0 to 2 mm, through brazing, etc. Further, if the inner diameter of the copper fine tube comes to be so fine, such as, about from 0.5 to 1. 5 mm, the resistance increases in the flow passage, and thereby lowering an amount of the working fluid; however, it is confirmed from experiments, that an improvement is prevailing on the cooling performance.

In this Fig. 1 is shown the condition, however, where the coolant separation flow passages 57 at the downstream side is already attached in one portion of the "U" shaped flow passage 53, while the other one of the coolant separation flow passage 56 at the upstream side, as shown by a white outlined arrow, is just to be attached in the other portion of the "U" shaped flow passage 53 (i.e., the portion indicated by a broken line "A" in the figure). Further, thereafter, upon the upper surface of the base-plate member 51, on which the coolant separation flow passages 56 and 57 are attached within the flow passage 53 formed therein, the cover member 52 is put on, and both of those are connected therebetween, through packing and screws, or the brazing, etc.; thereby, being sealed up, in a liquid-tight manner.

In this manner, since the heat-receiving (or cooling) jacket 50, according to the embodiment shown in Fig. 1, can be manufactured through a simple process, as was mentioned in the above; such as, inserting and fixing (i.e., connecting through the brazing, for example) the coolant separation flow passages 56 and 57, each of which can be made by combining the fine tubes in a plural number of pieces thereof in advance, into a portion of the flow passage (i.e., the recess or convex portion), which is formed in the base-plate member 51 through the press work, etc., for example, and thereafter attaching the cover member 52 upon an opening portion of an upper surface thereof; therefore, it is possible to lower the manufacturing const thereof, comparing to that of the conventional heat-receiving (or cooling) jacket, greatly.

And, according to the liquid cooling system of the electronic apparatus, having the heat-receiving (or cooling) jacket 50 therein, the details of which was explained in the above, as was indicted by the arrow in the Fig. 1 mentioned above, the liquid coolant discharged from the circulation pump 70 flows into the inside of the jacket 50 from the flow inlet 54 thereof. Thereafter, the liquid coolant passes through the inside of the plural numbers of fine tubes within the separation flow passages 56, which is inserted and fixed in the upstream side of the "U" shaped flow passage formed within the jacket, and further, passing through the inside of the plural numbers of fine tubes within the separation flow passage 57, which is inserted and fixed in the downstream side thereof, it comes out from the flow outlet 55, thereby being guided into the radiator portion 60 for radiating the heat of the liquid coolant into an outside thereof, in the example shown in Fig. 3 mentioned above, for example.

Further, according to the structure of the heat-receiving (or cooling) jacket 50 mentioned above, since the liquid coolant flowing into the inside thereof passes through the inside of the large number of fine tubes in the separation flow passages 56 and 57, and in addition thereto, thermally, since those fine tubes are connected with the base-plate member 51 and the cover member 52, building up the jacket 50 mentioned above, therefore it can contact with the jacket 50 with much more surface area thereof, so as to conduct the heat-exchange therebetween. Thus, the heat-receiving (or cooling) jacket 50 can transfer the heat-generation within the CPU 200, i.e., the heat-generating element, being in contact with the lower surface thereof, into the liquid coolant flowing within the inside thereof, with high or superior efficiency. Thereby, the CPU can maintain the temperature thereof within a range, which is necessary for maintaining or ensuring the normal operation thereof. Furthermore, a reference numeral 210 in the figure depicts a circuit board, mounting the CPU 200 in a part thereof.

Following to the above, Fig. 4 attached herewith shows the details of the interior structure of the heat-receiving (or cooling) jacket 50, wherein the recess or concave portion is formed into the "I" shaped flow passage within the jacket, differing from the flow passages of the "U" shape mentioned above, through the press work, etc., for example. However, in this instance, as is apparent from the figure, the flow inlet 54 and the flow outlet 55 are formed on the two (2) side surfaces of the base-plate portion 51, opposing to each other. And, in a portion of the "I" shaped flow passage defined by that recess or concave portion, in more details thereof, at a central portion thereof, there is attached the coolant separation flow passage (portion) 56, which is also constructed by combining (connecting) the fine tubes made of copper or the like, in a plural number of pieces thereof, through the brazing, etc. And, thereafter, the cover member 52 is put on it, covering the entire surface thereof, and it is also same to that of mentioned above, that the both are connected therebetween, so as to be sealed up, in a liquid-tight manner.

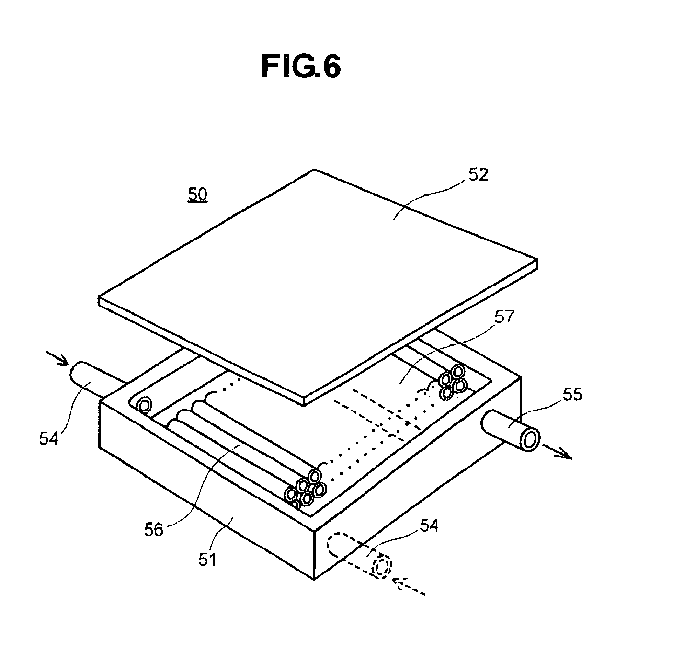

Further, Fig. 5 attached herewith shows a variation of the heat-receiving (or cooling) jacket 50 mentioned above, in the cross-section view thereof. In this variation, as is apparent from the figure, hollows or cavities 511 and 512 are formed on the base-plate member 51 shown in Fig. 1; i.e., at the positions corresponding to both ends of the fine tubes of the coolant separation flow passages (portions) 56 and 57. With such the structure, the brazing material 513 in excess flows into the hollows 511 and 512 to be absorbed therein, if being applied in an amount being much more than that necessary for connecting between the fine tubes and the base-plate member 51; therefore, it will never block the openings of those fine tubes. Accordingly, it is possible to apply the brazing material in an amount thereof, being much more than that necessary in a little bit, thereby connecting the fine tubes and the base-plate member 51 with certainty, but without blocking the openings thereof with the brazing material. With this, it is possible to manufacture the heat-receiving (or cooling) jacket having high heat transfer into the liquid flowing within the fine tubes, with stability.

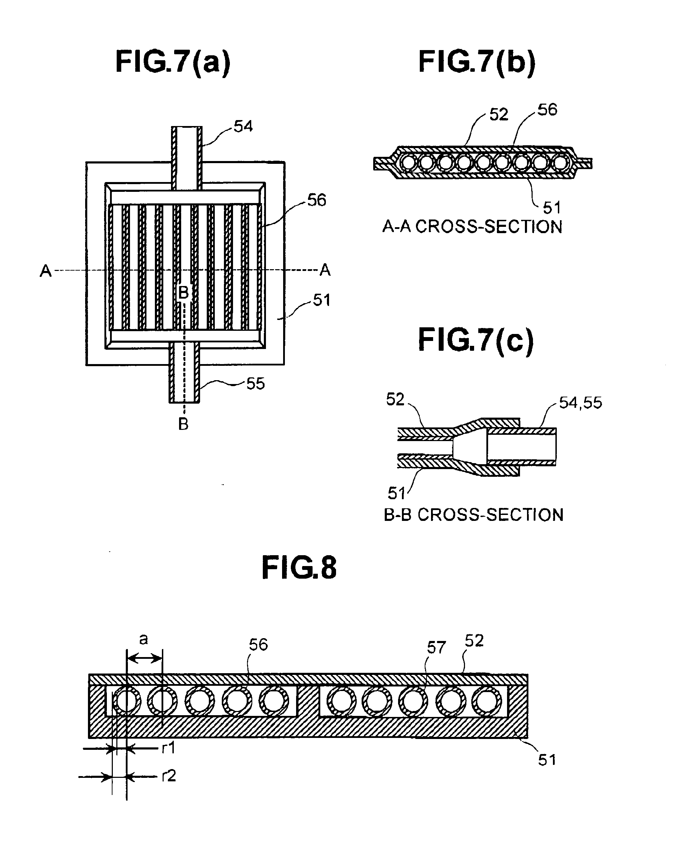

Furthermore, as other manufacturing method of the heat-receiving (or cooling) jacket 50, as is shown in Figs. 7 (a) to 7(c). After building up the coolant separation flow passage (portion) 56 by combining plural pieces of the fine tubes in a bundle, as well as, the plate-like member 51 and the cover member 52 from a plate, on which are formed the recess portion at the positions corresponding to the flow inlet 54 and the flow outlet 55 (the plate-like member 51 and the cover member 52 may be same in the configuration thereof), all the base-plate member 51, the cover member 52, the coolant separation flow passage (portion) 56, and also ports to be the flow inlet 54 and the flow outlet 55 are connected or bonded together, at the same time. With such the present method, it is possible to manufacture the above with a very simple process and a low cost.

Also, with such the structure of the heat-receiving (or cooling) jacket 50, since the liquid coolant flowing into the inside thereof passes within the large numbers of fine tubes of the separation flow passage 56, in the similar manner to the above, and further since those fine tubes are thermally connected with the base-plate member 51 and the cover member 52 of the jacket 50 mentioned above; therefore, the liquid coolant can be in contact with the jacket 50, upon a surface area thereof, much more, thereby conducting the heat conversion, effectively. Thus, in the same manner to that mentioned above, the heat-receiving (or cooling) jacket 50 can transfer the heat-generation within the CPU 200, i.e., the heat-generating element, being in contact with the lower surface thereof, into the liquid coolant flowing within an inside thereof, with superior or high efficiency, thereby keeping the CPU within a range of the temperature, being necessary for maintaining the normal operation thereof.

Also as is shown in Fig. 8, aligning the fine tubes 56 or 57 at an appropriate distance between them enables building-up of the flow passages for the liquid coolant, with using not only an inside the fine tubes, but also the spaces defined between the neighboring fine tubes. With this, it is possible to transfer the heat from both wall surfaces of the fine tube; i.e., the interior wall and the exterior wall thereof, into the liquid coolant, thereby achieving the heat conversion with superior or high efficiency, with only a small number of pieces of the fine tubes. Also, for example, if assuming that an inner radius and an outer radius of the tine tube are "r1" and "r2", respectively, and if bringing the distance "a" between the neighboring fine tubes to be as follows:

$$a = \pi \, (r1^2 + r2^2)/(2 \, r2) \qquad \text{(Eq. 1)}$$

then, the cross-section area defined between the neighboring fine tubes is equal to that of the fine tube, thereby achieving uniformity in the amount of the liquid flow therein; i.e., equalization of the liquid coolant flowing within both of them.

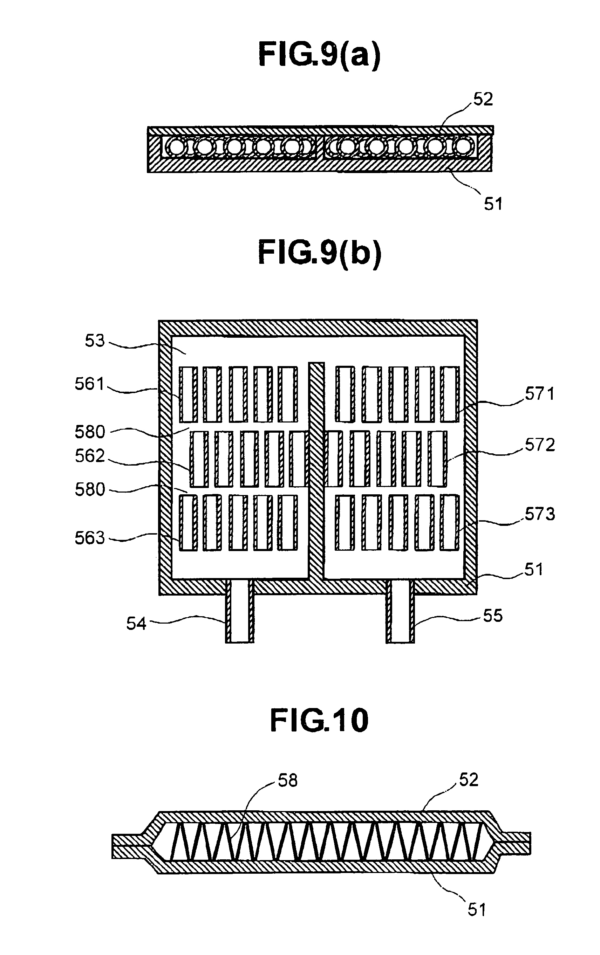

Or, alternately, as shown in Fig. 10, in the place of the fine tubes 56 and 57 mentioned above, it is also possible to apply a plate 58, being formed into a corrugate-like, in the configuration thereof, to be inserted and fixed within the base-plate member 51 and the cover member 52 of the jacket 50 mentioned above, thereby forming the fine flow pas sages therein. Furthermore, with provision of rise-up of slits on the surface of the corrugate-like plate 58, for use of accelerating turbulences, it is possible to increase the heat transfer into the liquid coolant.

Also, Fig. 6 attached herewith shows an example, as further other embodiment, wherein the coolant separation flow passage (portion) 56 or 57 to be inserted into the flow passage of the "U" shape or the "I" shape, i.e., the recess portion, which is formed within the jacket through the press work, etc. , it is made up by laminating the plural number of pieces of the fine tubes of copper or the like, not into one (1) stage as was mentioned above, but in the place thereof, into plural numbers of stages (for example, two (2) stages, in this example) thereon, to be tied up (or connected) in a bundle thereof. Further, in this figure, the structure is shown by solid lines, corresponding to the flow passage of the "I" shape, while the flow inlet 54 and so on, by broken lines, corresponding to the flow passage of the "U" shape mentioned above.

Further, for the person skilled in the art, it is apparent that, with the structure of the further other embodiment according to the present invention, the same operation and effect can be obtained. Also, though not shown in the figure, but for the person skilled in the art, it is apparent that further other variation can be made, appropriately.

For example, as is shown in Figs. 9(a) and 9 (b) attached herewith, the plural pieces of the fine tubes 561, 562, 563, 571, 572 and 573 are divided or separated into a plural number (such as, into three (3) in this example), along with the flow of the liquid coolant within the inside of the heat-receiving (or cooling) jacket 50 (i. e., in the vertical direction in the figure), and each line of the fine tubes (i.e., those aligned in the horizontal direction in the figure) is shifted at the central portion thereof by a half of the diameter thereof. In this figure, a reference numeral 580 depicts gaps; each being provided between the lines of those divided fine tubes. With such a structure, i.e., due to the separation of the fine tubes and the shifting between the centers of the fine tubes neighboring with, in the flow direction, it is possible to interrupt temperature boundary layers within the liquid coolant flowing therein, and also accelerate the turbulences within the flow of the liquid coolant within the heat-receiving (or cooling) jacket 50, thereby obtaining high performances.

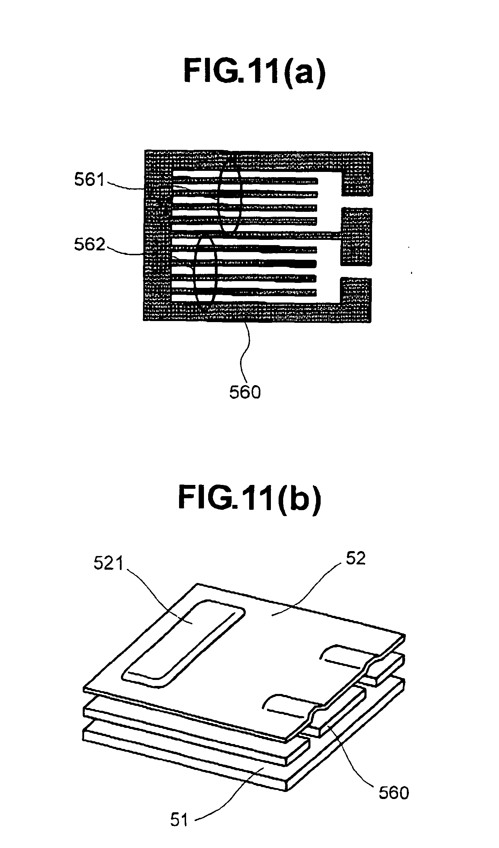

Further, although being similar to the structure and the manufacturing method thereof as shown in Figs. 7 (a) to 7 (c), however it is also possible to apply a slit plate 560, in the place of the line or bundle of fine tubes mentioned above, as is shown in Figs. 11 (a) and 11 (b) attached herewith. Thus, with this variation, the slit plate 560 has lines of slits 561 and 562 within the flow passage in the heat-receiving (or cooling) jacket 50, for forming the fine flow passages therein, but in the place of those defined by the fine tubes. On the other hand, a hollow or cavity portion 521 is formed in the cover member 52, for connecting between the slit lines 561 and 562. The base-plate 51, the slit plate 560 and the cover member 52 are piled up, and they are connected or fixed as one body, at the same time. With such the structure, since the base-plate 51, the slit plate 560 and the cover member 52 can be made from a copper plate or the like, only through the press work; therefore, it is possible to manufacture the heat-receiving (or cooling) jacket, with the manufacturing cost, being extremely cheap.

Namely, as was mentioned fully in the above, according to such the present invention as was mentioned above, with applying the heat-receiving (or cooling) jacket into the cooling system, which is simple, in the manufacturing process thereof, and then easy to reduce the manufacturing cost thereof, it is possible to provide an electronic apparatus having a cooling system therein, being applicable into the personal computers of so-called the desktop-type and the notebook-type, as well as, the server, etc., as the cooling system thereof, which are in tendency that the sales prices thereof come down, every year, due to the effect of mass production thereof, and at the same time, with applying the liquid cooling method, which is superior in the cooling efficiency, as the cooling system of such the electronic apparatus, it is possible to achieve a superior effect that the entire structure thereof can be made further small in the sizes.

The present invention may be embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

List of Reference Signs

50     heat receiving jacket (cooling jacket)

51     base plate member

52     cover member

53     flow passage

54     inlet

55     outlet

56 57     coolant separation flow passages

60     radiator portion

61     fins

62     fan

70     circulation pump

81 82 84     tubes (conduits)

100     housing (of main body)

101     front panel portion

102     driver apparatus

103     memory portion

104     cover portion

105     electronic circuit portion (including liquid cooling system)

106     electric power portion

200     chip

210     circuit board

511 512     cavities; hollows

513     brazing material

521     hollow/cavity portion

560     slit plate

561 562 563 571 572 573     fine tubes

580     gaps

**Claims**

1. Liquid cooling system for an electronic apparatus, comprising:

a cooling jacket (50) being thermally connected with a semiconductor element installed within the electronic apparatus, for transmitting the generated heat thereof into a liquid coolant flowing within the inside thereof,

a radiator (60) for discharging the heat transmitted to the liquid coolant within the cooling jacket (50) to the outside of the apparatus, and

a circulation pump (70) for circulating the liquid coolant within a loop, including therein the cooling jacket (50) and the radiator (60), wherein the heat-receiving jacket (50) comprises:

- a base-plate portion (51) being about plate-like in its outer configuration and open in the upper surface side thereof, made of a material superior in heat conductivity, and further formed with a flow inlet (54) and a flow outlet (55) for the liquid coolant, as well as a flow passage (53) formed within the inside thereof, directing the liquid coolant flow from the flow inlet (54) to the flow outlet (55),

- a coolant division portion (56, 57) being made of a material superior in heat conductivity so that the liquid coolant dividedly flows inside of fine tubes, and

- a cover portion (52) attached to the base-plate portion (51) on the open upper surface side thereof, after disposing the coolant division portion (56, 57) in a portion of the flow passage defined within the base-plate portion (51).

2. Liquid cooling system according to claim 1, wherein the coolant division portion (56, 57) is made up with a plural number of pieces of fine tubes tied in a bundle.

3. Liquid cooling system according to claim 1 or 2, wherein the coolant division portion is made up with a plate being formed into a corrugated configuration.

4. Liquid cooling system according to any of claims 1 to 3, wherein the coolant division portion is made up with a plate being formed with plural slits.

5. Liquid cooling system according to any of claims 1 to 4, wherein the flow passage directing the liquid coolant flow from the flow inlet (54) to the flow outlet (55) is formed into a "U" shape within the base-plate portion (51) building up the cooling jacket (50).

6. Liquid cooling system according to any of claims 1 to 4, wherein the flow passage directing the liquid coolant flow from the flow inlet (54) to the flow outlet (55) is formed into an "I" shape within the base-plate portion (51) building up the cooling jacket (50).

7. Liquid cooling system according to any of claims 1 to 6, wherein the coolant division portion for building up the cooling jacket (50) is made up by connecting a plural number of pieces of the fine tubes while aligning them in one stage thereof.

8. Liquid cooling system according to any of claims 1 to 6, wherein the coolant division portion for building up the cooling jacket (50) is made up by connecting a plural number of pieces of the fine tubes while aligning them in a plural number of stages thereof.

9. Liquid cooling system according to any of claims 1 to 8, wherein the fine tubes of the coolant division portion (56, 57) for building up the cooling jacket (50) have an inner diameter of 0.5 to 1.5 mm.

10. Electronic apparatus, comprising:

a heat-generating semiconductor element (200) being installed within the inside of a housing thereof, which element necessitates cooling for maintaining normal operation thereof, and

a liquid cooling system according to any of claims 1 to 9.

11. Electronic apparatus according to claim 10, comprising:

a heat-generating semiconductor element (200), being installed within the inside of a housing thereof, which element necessitates cooling for maintaining normal operation thereof, and

a liquid cooling system, being provided within the housing or in a part thereof, and comprising:

a cooling jacket (50) being thermally connected with the semiconductor element (200) for transmitting the generated heat thereof into a liquid coolant flowing within the inside thereof,

a radiator (60) for discharging the heat transmitted to the liquid coolant within the cooling jacket (50) to the outside of the apparatus, and

a circulation pump (70) for circulating the liquid coolant within a loop, including therein the cooling jacket (50) and the radiator (60), wherein the heat-receiving jacket (50) comprises:

- a base-plate portion (51) being about plate-like in its outer configuration and open in the upper surface side thereof, made of a material superior in heat conductivity, and further formed with a flow inlet (54) and a flow outlet (55) for the liquid coolant, as well as a flow passage (53) formed within the inside thereof, directing the liquid coolant flow from the flow inlet (54) to the flow outlet (55),

- a coolant division portion (56, 57) being made of a material superior in heat conductivity, so that the liquid coolant dividedly flows inside of fine tubes, and

- a cover portion (52) attached to the base-plate portion (51) on the open upper surface side thereof, after disposing the coolant division portion (56, 57) in a portion of the flow passage defined within the base-plate portion (51).

12. Electronic apparatus according to claim 10 or 11, wherein the coolant division portion (56, 57) is made up with a plural number of pieces of fine tubes tied in a bundle.

13. Electronic apparatus according to any of claims 10 to 12, wherein the coolant division portion is made up with a plate being formed into a corrugated configuration.

14. Electronic apparatus according to any of claims 10 to 13, wherein the coolant division portion is made up with a plate being formed with plural slits.

15. Electronic apparatus according to any of claims 10 to 14, wherein the flow passage directing the liquid coolant flow from the flow inlet (54) to the flow outlet (55) is formed into a "U" shape within the base-plate portion (51) building up the cooling jacket (50).

16. Electronic apparatus according to any of claims 10 to 14, wherein the flow passage directing the liquid coolant flow from the flow inlet (54) to the flow outlet (55) is formed into an "I" shape within the base-plate portion (51) building up the cooling jacket (50).

17. Electronic apparatus according to any of claims 10 to 16, wherein the coolant division portion for building up the cooling jacket (50) is made up by connecting a plural number of pieces of the fine tubes while aligning them in one stage thereof.

18. Electronic apparatus according to any of claims 10 to 16, wherein the coolant division portion for building up the cooling jacket (50) is made up by connecting a plural number of pieces of the fine tubes while aligning them in a plural number of stages thereof.

19. Electronic apparatus according to any of claims 10 to 18, wherein the fine tubes of the coolant division portion (56, 57) for building up the cooling jacket (50) have an inner diameter of 0.5 to 1.5 mm.

# FIG.1

# FIG.2

# FIG.3

# FIG.4

# FIG.5

# FIG.6

# FIG.7(a)

54

56

A ——————————— A

B

51

55

B

# FIG.7(b)

52    56

51

A-A CROSS-SECTION

# FIG.7(c)

52                          54,55

51

B-B CROSS-SECTION

# FIG.8

a        56              57    52

r1

r2

51

# FIG.9(a)

# FIG.9(b)

# FIG.10

# FIG.11(a)

561
562
560

# FIG.11(b)

521
52
560
51

European Patent
Office

**EUROPEAN SEARCH REPORT**

Application Number

EP 04 02 1061

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | DE 41 31 739 A1 (BEHR INDUSTRIETECHNIK GMBH & CO., 7000 STUTTGART, DE; BEHR INDUSTRIETE) 1 April 1993 (1993-04-01) * the whole document * | 1,3,6, 10,13,16 | H01L23/473 |
| X | PATENT ABSTRACTS OF JAPAN vol. 010, no. 285 (E-441), 27 September 1986 (1986-09-27) -& JP 61 104647 A (HITACHI LTD), 22 May 1986 (1986-05-22) | 1,6,10, 16 | |
| A | * the whole document * | 11 | |
| X | PATENT ABSTRACTS OF JAPAN vol. 011, no. 367 (E-561), 28 November 1987 (1987-11-28) -& JP 62 139346 A (HITACHI LTD), 23 June 1987 (1987-06-23) * the whole document * | 1,4-6, 10,14-16 | |
| A | PATENT ABSTRACTS OF JAPAN vol. 2002, no. 04, 4 August 2002 (2002-08-04) -& JP 2001 358270 A (MITSUBISHI ELECTRIC CORP; NAKAJIMA HIDEO), 26 December 2001 (2001-12-26) | 2,11 | **TECHNICAL FIELDS SEARCHED (Int.Cl.7)** H01L |
| A | * the whole document * | 2,7,8, 11,12 | |
| A | PATENT ABSTRACTS OF JAPAN vol. 005, no. 129 (E-070), 19 August 1981 (1981-08-19) -& JP 56 067949 A (HITACHI LTD), 8 June 1981 (1981-06-08) * the whole document * | 2,11 | |
| A | EP 1 175 135 A (MITSUBISHI MATERIALS CORPORATION) 23 January 2002 (2002-01-23) * the whole document * | 1,10 | |

-/--

The present search report has been drawn up for all claims

| Place of search | Date of completion of the search | Examiner |
|---|---|---|
| The Hague | 6 April 2005 | Zeisler, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................
& : member of the same patent family, corresponding document

EPO FORM 1503 03.82 (P04C01)

**European Patent Office**

## EUROPEAN SEARCH REPORT

Application Number

EP 04 02 1061

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | PATENT ABSTRACTS OF JAPAN vol. 2003, no. 07, 3 July 2003 (2003-07-03) -& JP 2003 078270 A (HITACHI LTD), 14 March 2003 (2003-03-14) * the whole document * ----- | 1,10 | |
| | | | TECHNICAL FIELDS SEARCHED (Int.Cl.7) |

The present search report has been drawn up for all claims

| Place of search | Date of completion of the search | Examiner |
|---|---|---|
| The Hague | 6 April 2005 | Zeisler, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.........................................................................................
& : member of the same patent family, corresponding document

EPO FORM 1503 03.82 (P04C01)

**EP 1 564 809 A1**

## ANNEX TO THE EUROPEAN SEARCH REPORT
## ON EUROPEAN PATENT APPLICATION NO.

EP 04 02 1061

This annex lists the patent family members relating to the patent documents cited in the above-mentioned European search report.
The members are as contained in the European Patent Office EDP file on
The European Patent Office is in no way liable for these particulars which are merely given for the purpose of information.

06-04-2005

| Patent document cited in search report | | Publication date | Patent family member(s) | | Publication date |
|---|---|---|---|---|---|
| DE 4131739 | A1 | 01-04-1993 | CH | 685140 A5 | 31-03-1995 |
| | | | FR | 2681757 A1 | 26-03-1993 |
| | | | IT | 1255588 B | 09-11-1995 |
| JP 61104647 | A | 22-05-1986 | NONE | | |
| JP 62139346 | A | 23-06-1987 | NONE | | |
| JP 2001358270 | A | 26-12-2001 | NONE | | |
| JP 56067949 | A | 08-06-1981 | NONE | | |
| EP 1175135 | A | 23-01-2002 | JP | 2002098454 A | 05-04-2002 |
| | | | EP | 1175135 A1 | 23-01-2002 |
| | | | US | 2002101718 A1 | 01-08-2002 |
| JP 2003078270 | A | 14-03-2003 | CN | 1455954 A | 12-11-2003 |
| | | | WO | 03024177 A1 | 20-03-2003 |
| | | | TW | 540289 B | 01-07-2003 |
| | | | US | 2004008475 A1 | 15-01-2004 |

For more details about this annex : see Official Journal of the European Patent Office, No. 12/82